# EUROPEAN PATENT APPLICATION

(11) **EP 1 001 428 A2**
(43) Date of publication of application: **17.05.2000**
(21) Application number: 99308957.2
(22) Date of filing: 10.11.1999
(51) Int. Cl.: G11C 7/16

(54) **Digital audio recording and reproducing apparatus**

(30) Priority: 10.11.1998 JP 31881098; 25.06.1999 JP 17967099; 25.06.1999 JP 17973899; 25.06.1999 JP 17973999; 25.06.1999 JP 17995199
(71) Applicant: TDK Corporation, Chuo-ku, Tokyo (JP)
(72) Inventor: Kobayashi, Nobuyuki, c/o TDK Corporation, Tokyo (JP); Fujii, Ken, c/o TDK Corporation, Tokyo (JP)
(74) Representative: Mohun, Stephen John

(57) **Abstract**

In a digital audio recording and reproducing apparatus, an analog audio signal supplied from a microphone (11) is converted into digital audio data, and after compressing the digital audio data such that the analog audio signal of sixty seconds is converted into digital data of not larger than 100K bytes, compressed digital audio data is stored in an internal solid state memory (17) and/or external solid state memory (18) as data files having a file format which can be directly handled by an external computer (27) . Upon reproduction, after decompressing the digital audio data read out of the memory (17/18), decompressed digital audio data is converted into an analog audio signal, and the thus converted analog audio signal is reproduced by a speaker (24) or earphone. The digital audio data file stored in the memory (17/18) can be directly and easily transferred to the computer (27) within a short time by means of the external memory (18), connection cable (29), communication line and transmitter without using special connection cable and data format converting driver software. Digital audio data can be also transferred from the computer (27) to the digital audio recording and reproducing apparatus in a similar manner.

## Description

The present invention relates to a digital audio recording and reproducing apparatus comprising an A/D converter for converting an analog audio signal collected by a microphone into digital audio data, a digital compression circuit for compressing said digital audio data to generate compressed digital audio data, an internal solid state memory for storing said compressed digital audio data, a digital decompression circuit for decompressing said compressed digital audio data read out of said internal solid state memory to generate decomposed digital audio data, a D/A convener for converting said decompressed digital audio data into an analog audio signal, and a reproducing means for reproducing said analog audio signal supplied from said D/A converter.

Heretofore, an audio tape recorder has been widely used as an apparatus for recording and reproducing audio or speech information. However, the audio tape recorder has various problems. That is to say, the audio tape recorder includes a mechanical driving portion which requires a cyclic maintenance, and it is difficult to make a small and light tape recorder. A battery or batteries have to be exchanged frequently, because a power consumption of the tape recorder including the driving mechanism is large. An audio tape is liable to be expanded and cut, and a quality of the reproduced sound might be deteriorated. Further, random access to the recorded audio information cannot be effected, and therefore desired audio information cannot be retrieved easily and promptly.

Furthermore, there has been also proposed an audio recording and reproducing apparatus using an opto-magnetic type record medium. In such an apparatus, there is no problem due to a deterioration of the record medium, but mechanical portions for driving the record medium as well as a recording and reproducing opto-magnetic head are still required, and thus the apparatus is liable to be damaged by mechanical shock and vibration.

In order to solve the above problems, there has been proposed a digital audio recording and reproducing apparatus (generally called IC recorder) using a solid state memory as an audio information record medium which does not require a mechanical driving portion. Such a digital audio recording and reproducing apparatus is described, for instance in Japanese Patent Application Laid-open Publication Kokai Hei 2-238500. In this known apparatus, a semiconductor memory such as EEPROM is used as an internal solid state memory installed in the apparatus. After converting an analog audio signal into digital audio data, the digital audio data is compressed and the thus compressed digital audio data is stored in the semiconductor memory. Upon reproduction, after reading the compressed digital audio data out of the semiconductor memory, the compressed digital audio data is decompressed and the thus decompressed digital audio data is converted into an analog audio signal, and the analog audio signal is reproduced by a loud speaker or earphone or headphone.

In the above mentioned digital audio recording and reproducing apparatus, since the digital audio data obtained by compressing the audio information is stored in the semiconductor memory, it is no longer necessary to provide the driving mechanism, and the apparatus can be small in size and light in weight, can be protected against mechanical shock, and can be easily transported by a user. Furthermore, random access to the stored audio information can be performed, and desired audio information can be reproduced promptly. Moreover, digital audio data can be stored with adding various kinds of digital information. For instance, when identification data for respective recorded audio data is recorded, the stored audio information can be retrieved efficiently.

As stated above, in the known digital audio recording and reproducing apparatus, the audio information is recorded on the semiconductor memory as the digital audio data, this digital data is preferably inputted into a computer. That is to say, the digital audio data stored in the internal semiconductor memory is supplied to the computer and is stored and managed in the computer on a memory of the computer. The digital audio data can be further transmitted to another computer via a communication means such as internet as a voice mail.

In the digital audio recording and reproducing apparatus, upon the recording, the digital audio data is stored in a semiconductor memory installed in the apparatus. In order to make a recording time longer, to manage the stored audio data, and to send the stored audio data to another similar apparatus or computer, an external memory can be detachably connected to the apparatus and the digital audio signal is also stored in this external memory. As such an external memory, there have been proposed various kinds of memories. For instance, in Japanese Patent Application Laid-open Publications Kokai Hei 9-52811 and 10-111917, there have been proposed to utilize a semiconductor memory such as flash memory and smart media and a solid state memory such as memory stick as the removable memory. By using such an external solid state memory is used to send the digital audio data to the computer.

However, in the known digital audio recording and reproducing apparatus, the D/A conversion and audio data compression have not been determined on the basis of the processing on the computer. In order to treat the digital audio data recorded in the digital audio recording and reproducing apparatus on the external computer, the D/A conversion and audio compression have to be common both in the computer and in the digital audio recording and reproducing apparatus. Therefore, when the computer operates in the environment of Windows (registered trade mark), the audio file formed by the digital audio recording and reproducing apparatus should have a file format which can be treated in the environment of Windows. Therefore, in order to treat the digital speech data recorded by the known digital audio recording and reproducing apparatus on the computer, it is necessary to use a software for converting the data format and file format of the recorded digital audio data into those compatible to the computer. This results in tat the digital audio data could not be simply transferred to the computer and a data transfer cost is also increased.

In order to transfer the digital audio data recorded by the digital audio recording and reproducing apparatus directly to the computer, a special connection cable has to be used and at the same time a special converting driver software has to be installed into the computer. Therefore, in order to transfer the digital audio data to outside computers, a user should always bring the special connection cable and driver software with him. This apparently decreases the utilization of the digital audio recording and reproducing apparatus to a large extent.

Furthermore, when the recorded digital audio data is converted with the aid of the conversion software, a data amount is increased, and therefore the data transmission requires a longer time and burdens the user with a higher communication cost. In an extreme case, a large data amount might exceed a data transmission capacity of a communication system to be used, which is not suitable for practical applications.

In the known digital audio recording and reproducing apparatus using the above mentioned external memory for recording the digital audio data, if the external memory is erroneously removed from the apparatus during the recording operation, not only is the recording operation forcedly interrupted, but also the digital audio data so far recorded on the external memory cannot be correctly reproduced. Therefore, when the external memory is removed from the apparatus by an error during the recording operation, all the data stored on the external memory during the relevant recording operation is wasted.

For instance, in the conventional audio recording and reproducing apparatus using a magnetic tape such as the compact cassette, it is common to provide a mechanical lock for preventing the installed tape cassette from being removed during the recording and reproducing operation. Such a mechanical lock may be provided also on the digital audio recording and reproducing apparatus. However, since the digital audio recording and reproducing apparatus is generally small, it is difficult to find a space for providing such a mechanical lock. Moreover, a large force might be applied to the external memory, and in an extreme case, the external memory might be damaged by the mechanical lock.

As explained above, in the digital audio recording and reproducing apparatus using a removable memory as the external solid state memory, the external memory may be used instead of the internal solid state memory or may be used together with the internal memory. In a latter case, the internal and external solid state memories form jointly a wide storage area for the digital audio data.

In comparison with the analog audio recording and reproducing apparatus using the conventional magnetic tape cassette, the digital audio recording and reproducing apparatus has the merit that random access can be performed. Due to this function, the digital audio recording and reproducing apparatus has a repeat reproduction function in which a same digital data file is reproduced repeatedly. For instance, in Japanese Patent Application Laid-open Publication Kokai Hei 10-187200, there is disclosed a digital audio recording and reproducing apparatus having the repeat reproduction function for reproducing repeatedly a desired digital audio data file selected from digital audio data files stored in the internal solid state memory.

However, in this known digital audio recording and reproducing apparatus, since only one digital audio data file can be reproduced repeatedly, the repeat reproduction function is useless for finding a desired digital audio file out of a plurality of digital audio data files stored in the internal memory.

In order to solve such a problem, there is also proposed a digital audio recording and reproducing apparatus having a plural file continuous reproduction function, in which a plurality of digital audio data files stored in the memory are successively reproduced in a continuous manner. In this plural file continuous reproduction function, a user can easily and promptly find a desired digital audio data file among a plurality of data files. However, in this known apparatus, since a plurality of data files are reproduced only once, if the user does not find a desired data file during the plural file continuous reproducing operation, this operation has to be carried out again.

In a known digital audio recording and reproducing apparatus having both the above mentioned repeat reproduction function and plural file continuous reproduction function, the repeat reproduction function is predominant. During the plural file continuous reproduction mode, when a repeat button is pushed, a digital audio data file which is just reproduced at this moment, is reproduced repeatedly. Therefore, if this repeatedly reproduced data file is found not to be a desired one, the plural file continuous reproduction mode has to be performed again. It is apparent that the above problem could not be solved sufficiently by this known apparatus.

In one application of the digital audio recording and reproducing apparatus, an advertising message is reproduced repeatedly at a shopping store. In the conventional digital audio recording and reproducing apparatus, since only a single digital audio data file can be reproduced repeatedly, this application is restricted. That is to say, in order to increase the advertising effect, it is sometimes preferable to reproduce a plurality of digital audio data files repeatedly. For instance, the advertising message preferably contains a content which could be reproduced every day and a content which is desired to be changed every day. Since the known digital audio recording and reproducing apparatus could not reproduce a plurality of digital audio data files in a repeated manner, when the advertising message contains a content which has to be changed every day, it is necessary to alter a whole advertising message every day. This is apparently inconvenient for the user.

One of the functions of the above mentioned digital audio recording and reproducing apparatus is an alarm function, in which a previously recorded alarm message is automatically reproduced at a suitable time which has been preset by the user. This alarm function is similar to a schedule management function. In the schedule management function, a special message can be reproduced or an alarm sound is generated at a preset time. The alarm function and schedule management function are specific to the digital audio recording and reproducing apparatus.

In the known alarm function and schedule management function, a digital audio data file of a message to be reproduced at a preset time is stored in a data storage area of the memory in which digital audio data files of normal speech are stored. Any desired digital audio data file stored in the normal data storage area can be selectively erased in accordance with a predetermined erasing operation, and an alarm data file can be also erased by the same erasing operation. Therefore, there is a rather large possibility that the digital data file of the alarm message might be erroneously erased.

In order to solve such a problem, the digital data file of the alarm message may be denoted by adding thereto a special mark. However, even if such a mark is added, inadvertent erasing of the alarm message is still possible Furthermore, in the digital audio recording and reproducing apparatus, it is usual to provide a function for erasing all the digital audio data files at once. In this erasing mode, the alarm message might be erroneously erased together with the normal messages.

Further, since the digital audio recording and reproducing apparatus is a portable device, it is energised by a power source including a battery or batteries. In order to prolong the recording and reproducing time, various portions have been designed to save a power. However, although a power consumption is decreased, the battery has a finite life time. Therefore, a residual capacity of a battery is displayed or a remaining recording time is displayed. It has been also proposed to generate an alarm when an output voltage of the power source reaches a level which is slightly higher than a threshold voltage below which the apparatus could not work satisfactorily.

In such an apparatus, when a user is aware of such an alarm displayed, for instance on a liquid crystal display during the recording operation and takes a normal operation for stopping the recording operation, audio information so far recorded is not wasted and can be reproduced correctly. However, there is a rather large possibility that the user is not aware of the alarm. Then, the recording operation is continued until the output voltage of the power source is decreased to to threshold value. When the output voltage becomes lower than the threshold value, to recording operation is suddenly stopped. In such a case, although the digital audio data is stored in the internal memory, the data management information stored in the RAM is wasted. When the recording operation is carried out using the external memory, the data management information stored in the RAM cannot be transferred to the external memory. Therefore, the digital audio data stored in the internal memory or external memory can never be read out. In this manner, when the recording operation is stopped due to the decrease in the battery voltage, the audio information so far recorded is wasted. This might reduce the performance of the digital audio recording and reproducing apparatus.

In order to overcome such a problem, it is further proposed to provide a back-up battery in addition to the main battery. For instance, in Japanese Patent Application Publication Kokai Hei 10-187200, there is disclosed a digital audio recording and reproducing apparatus including a back-up battery, by means of which at least the storage of the digital audio data file and data management information into the internal memory and RAM, respectively can be performed. In such an apparatus, when the output voltage of the main battery is decreased to the threshold value, the data management information stored in the RAM can be transferred to the FAT area of the external memory and stored therein. Therefore, the digital audio data so far stored in the external memory can be reproduced normally. It is apparent that such an operation can be performed only when the output voltage of the back-up battery is higher than the threshold value. However, if the back-up battery is also discharged and when its output voltage is lower than the threshold value, the above mentioned recording operation cannot be performed correctly and the recorded audio information cannot be reproduced. Since the output voltage of the back-up battery is not checked, even if it is deceased lower than the threshold value, a possibility that the above miss operation occurs is very high.

Moreover, when the discharged back-up battery is not exchanged, there is a serious problem of a leakage of a battery liquid. Usually the back-up battery is provided at a location which could be accessed only with difficulty, it is very cumbersome to exchange the back-up battery, and thus a possibility of the leakage of battery liquid is very high.

Accordingly, it is desirable to provide a digital audio recording and reproducing apparatus in which digital audio data can be transmitted directly between the apparatus and an external computer.

It is also desirable to provide a digital audio recording and reproducing apparatus, in which even if an external solid state memory is removed from the apparatus during a recording operation using the external solid state memory, digital audio data currently recorded is not wasted and can be reproduced as usual.

It is also desirable to provide a digital audio recording and reproducing apparatus, in which a message consisting of a plurality of digital audio data files can be reproduced repeatedly, and a desired digital audio data file can be found easily and promptly.

Further it is desirable to provide a digital audio recording and reproducing apparatus, in which an alarm message file which is automatically reproduced at a preset time could not be erased by an operation for erasing a usual message.

It is also desirable to provide a digital audio recording and reproducing apparatus, in which even when a main battery voltage is decreased, digital audio data so far recorded can be saved and can be reproduced positively.

According to an embodiment of a first aspect of the invention, a digital audio recording and reproducing apparatus comprises:
an A/D converter for converting an analog audio signal collected by a microphone into digital audio data;
a digital compression circuit for compressing said digital audio data such that the analog audio signal of sixty seconds is converted into compressed digital audio data of not larger than 100K bytes;
an internal solid state memory for storing said compressed digital audio data;
a digital decompression circuit for decompressing said compressed digital audio data read out of said internal solid state memory to generate decompressed digital audio data;
a D/A converter for converting said decompressed digital audio data into an analog audio signal;
a reproducing means for reproducing said analog audio signal supplied from said D/A converter; and
an output means for outputting said compressed digital audio data to an external computer such that the compressed digital audio data has a file format which can be directly treated by the external computer.

In such digital audio recording and reproducing apparatus, the digital compression circuit is constructed such that the analog audio signal of sixty seconds, i.e. one minute,is converted into compressed digital audio data of not larger than 100K bytes, and the compressed digital audio data outputted to the external computer has a file format which can be directly treated by the computer. Therefore, the compressed digital audio data can be directly transferred between the digital audio recording and reproducing apparatus and the external computer, and it is no longer necessary to provide a special connection cable and data conversion software and the data transmission can be carried out within a very short time period. Moreover, a size of the digital audio data is sufficiently small so that the digital audio data can be transmitted between the apparatus and the computer by means of the conventional communication line. For instance, the digital audio data may be compressed in accordance with an audio coding system based on the ITU-T recommendation G723.1, and the file format of the compressed digital audio data may be WAVE file, while the computer works in Windows.

In a preferable embodiment of the digital audio recording and reproducing apparatus according to the first aspect of the invention, said output means for outputting the compressed digital audio data to the external computer comprises a connecting terminal for connecting detachably an external solid state memory. Then, the compressed digital audio data can be freely transferred between the internal solid state memory and the external solid state memory. That is to say, the compressed digital audio data stored in the external solid state memory can be simply transferred to the computer by inserting the external like as said internal solid state memory into the computer, and further a digital audio message formed by the computer may be transferred to the digital audio recording and reproducing apparatus by connecting the external solid state memory storing this message to the digital audio recording and reproducing apparatus.

Furthermore, when the external solid state memory is connected to the digital audio recording and reproducing apparatus, the external solid state memory may be used together with the internal solid state memory. Therefore, even if the internal solid state memory is full of the digital audio data, succeeding digital audio data may be stored in the external solid state memory without interrupting the recording operation. When the external solid state memory is full of the digital audio data, the recording operation can be continued by exchanging the external memory by another external memory.

Further, in the digital audio recording and reproducing apparatus embodying the first aspect of the invention, it is preferable to provide a means for transmitting the compressed digital audio data between the digital audio recording and reproducing apparatus and the external computer. Said transmitting means may comprise a cable connecting terminal to which one end of a connection cable is detachably connected, the other end of said connection cable being connected to the external computer. Said transmitting means may comprise a transmitter which transmits the compressed digital audio data by means of a radio wave signal or an optical signal to a receiver provided in the external computer. Furthermore, said transmitting means may comprises a modem and a communication connecting terminal connected to said modem.

Said internal solid state memory and external solid state memory are preferably formed by a non-volatile semiconductor memory without a back-up battery. It is preferable that the non-volatile semiconductor memory may be a small flash ROM such as SSFDC.

According to an embodiment of a second aspect of the invention, a digital recording and reproducing apparatus comprises:
an A/D converter for converting an analog audio signal collected by a microphone into digital audio data;
a digital compression circuit for compressing said digital audio data into compressed digital audio data;
an internal solid state memory for storing said compressed digital audio data;
a digital decompression circuit for decompressing said compressed digital audio data read out of said internal solid state memory to generate decompressed digital audio data;
a D/A converter for converting said decompressed digital audio data into an analog audio signal;
a reproducing means for reproducing said analog audio signal supplied from said D/A converter; and
an external memory connecting terminal for connecting detachably an external solid state memory for storing said compressed digital audio data instead of or together with said internal solid state memory;
   wherein when it is detected that the external solid state memory is removed from said external memory connecting terminal during a recording operation using the external solid state memory, the recording operation is temporally interrupted, and after detecting that the relevant external solid state memory is connected to said external memory connecting terminal, the interrupted recording operation is restarted.

In the previously-proposed digital audio recording and reproducing apparatus, when the recording operation is carried out by using the external memory, the compressed digital audio data is stored in sectors in a normal data storage zone of the external memory and data management information such as sector addresses, data size and distribution information are temporally stored in RAM of the central processing unit. When the recording operation is stopped, the data management information is read out of the RAM and is stored in a FAT zone of the external memory. Upon the reproduction, at first the data management information is read out of the FAT of the external memory, and then a desired digital audio data file is read out of the normal data storage zone of the external memory. Therefore, when the external memory is accidentally removed during the recording operation, although the digital audio data stored in the external memory is not broken, but since the data management information is not recorded on the external memory, the digital audio data could not be reproduced.

In digital audio recording and reproducing apparatus embodying the second aspect of the invention, when the external memory is removed during the recording operation, the data management information temporally stored in the RAM is held as it is, and when the relevant external memory is inserted again, the interrupted recording operation is restarted. When the recording operation is stopped, the data management information is read out of the RAM and is stored in the FAT area of the external memory. Therefore, the digital audio data which has been recorded before the external memory is removed can be reproduced in a usual manner.

In a preferable embodiment of the digital audio recording and reproducing apparatus according to the second aspect of the invention, the external solid state memory is detected to be removed from the external memory connecting terminal during the recording operation using the external solid state memory, a warning for requesting a user to insert the relevant external slid state memory to the apparatus. In this case, when it is detected that an external solid state memory different from the external slid state memory which has been removed during the recording operation is inserted into the apparatus, it is preferable to generate a warning for indication that the currently connected external solid state memory is different from that removed during the recording operation.

A digital audio recording and reproducing apparatus embodying a third aspect of the invention comprises:
an A/D converter for converting an analog audio signal collected by a microphone into digital audio data;
a digital compression circuit for compressing said digital audio data into compressed digital audio data;
an internal solid state memory for storing said compressed digital audio data;
a digital decompression circuit for decompressing said compressed digital audio data read out of said internal solid state memory to generate decompressed digital audio data;
a D/A converter for converting said decompressed digital audio data into an analog audio signal;
a reproducing means for reproducing said analog audio signal supplied from said D/A converter; and
an external memory connecting terminal for connecting detachably an external solid state memory for storing said compressed digital audio data instead of or together with said internal solid state memory;
   wherein said apparatus includes;
a normal reproduction mode in which a signal digital audio data file selected from digital audio date files stored in said internal solid state memory and/or external solid state memory is reproduced only once;
a single file repeat mode in which a single digital audio data file selected from digital audio date files stored in said internal solid state memory and/or external solid state memory is reproduced repeatedly;
a plural file continuous repeat mode in which a plurality of digital audio data files stored in said internal solid state memory and/or external solid state memory are successively reproduced only once; and
a plural file repeat mode in which a plurality of digital audio data files stored in said internal solid state memory and/or external solid state memory are successively reproduced in a repeated manner.

In digital audio recording and reproducing apparatus embodying the third aspect of the invention, since there is provided the plural file repeat mode in which a plurality of digital audio data files stored in said internal solid state memory and/or external solid state memory are successively reproduced in a repeated manner, a desired digital audio data file can be easily and promptly found out of a plurality of digital audio data files. Moreover, since a plurality of digital audio data files are successively reproduced repeatedly, it is easy to produce an advertising message at a shopping store and the applicability of the apparatus can be improved.

In digital audio recording and reproducing apparatus embodying the third aspect of the invention, in said plural file repeat reproduction mode, all digital audio data files or a selected number of digital audio data files stored in said internal solid state memory and/or external solid state memory may be successively reproduced in a repeated manner.

In a preferable embodiment of the digital audio recording and reproducing apparatus according to the third aspect of the invention, a plurality of digital audio data files are stored in said internal solid state memory and/or external solid state memory with ordinal file numbers, and in said plural file continuous reproduction mode, a plurality of digital audio data files from a digital audio data file having a file number denoted by a user to a digital audio data file having the last file number are successively reproduced. Then, unnecessary digital audio data files are not reproduced, and thus the retrieve can be performed within a short time period and the accuracy of retrieve can be improved.

Furthermore, in a preferable embodiment of the digital audio recording and reproducing apparatus according to the third aspect of the invention, during said plural file continuous reproduction mode or plural file repeat reproduction mode, when a repeat button is operated by a user in response to a reproduction of a desired speech, said plural file continuous reproduction mode or plural file repeat reproduction mode is automatically interrupted and said single file repeat reproduction mode is automatically started to reproduce repeatedly a currently reproduced digital audio data file. Then, the user can listen a content of said single digital audio data file repeatedly, and therefore a desired file can be accurately and positively retrieved.

A digital audio recording and reproducing apparatus embodying a fourth aspect of the invention comprises:
an A/D converter for converting an analog audio signal collected by a microphone into digital audio data;
a digital compression circuit for compressing said digital audio data into compressed digital audio data;
an internal solid state memory for storing said compressed digital audio data;
a digital decompression circuit for decompressing said compressed digital audio data read out of said internal solid state memory to generate decompressed digital audio data;
a D/A converter for converting said decompressed digital audio data into an analog audio signal; and
a reproducing means for reproducing said analog audio signal supplied from said D/A converter;
   wherein said internal solid state memory has a data zone divided into a normal data storage area storing digital audio data files of normal speeches and an alarm data storage area storing at least one digital audio data file of an alarm message, and the digital audio data file stored in the alarm data storage area could not be erased at least by a normal operation for erasing one or more digital audio data files stored in the normal data storage area.

In digital audio recording and reproducing apparatus embodying the fourth aspect of the invention, there are provided the normal reproduction mode and alarm reproduction mode, and when the normal reproduction mode is selected, only the normal data storage zone of the internal memory can be accessed, and when the alarm mode is selected, only the alarm data storage area can be accessed. Therefore, during the normal reproduction mode, the alarm message data stored in the alarm data storage area could never be erased, and a possibility of erasing the alarm data by an error can be reduced materially. Furthermore, it is also possible to utilize the alarm data storage area for storing a special message which should not be erased by the normal erasing operation, said special message being a message stored by a person which is different from a person who mainly uses the relevant apparatus. Moreover, when no alarm message is recorded, an alarm sound may be reproduced at a time present by the user.

A digital audio recording and reproducing apparatus embodying a fifth aspect of the invention comprises:
an A/D converter for converting an analog audio signal collected by a microphone into digital audio data;
a digital compression circuit for compressing said digital audio data into compressed digital audio data;
an internal solid state memory for storing said compressed digital audio data;
a digital decompression circuit for decompressing said compressed digital audio data read out of said internal solid state memory to generate decompressed digital audio data;
a D/A converter for converting said decompressed digital audio data into an analog audio signal;
a reproducing means for reproducing said analog audio signal supplied from said D/A converter;
a power source for energizing said circuits and including at least one battery; and
a battery check circuit for checking an output voltage of said power supply;
   wherein
when the output voltage of the power source is higher than a threshold value at which the apparatus could not work correctly, but becomes not higher than a first level, this condition is displayed;
when the output voltage of the power source is higher than said threshold value, but becomes not higher than a second level, this condition is displayed; and
when the output voltage of the power source becomes not higher than said second level during the recording operation, data management information for currently recorded digital audio data is automatically saved and the recording operation is automatically stopped.

In digital audio recording and reproducing apparatus embodying the fifth aspect of the invention, when the output voltage of the power source becomes not higher than the second level during the recording operation, the recording operation is automatically stopped without any manual operation of the user, and the data management information for the currently recorded digital audio data is automatically stored in a given storage area. Therefore, the stored digital audio data can be correctly reproduced without wasting the stored digital audio data. In this case, the automatic saving operation does not require any manual operation of the user, and thus the stored data can be positively saved.

In a preferable embodiment of the digital audio recording and reproducing apparatus according to the fifth aspect of the present invention, when the output voltage of the power source reaches a third level lower than said second level but is slightly higher than said threshold value, the power supply to the various portions of the apparatus is automatically stopped. Then, it is judged that the operation of the apparatus is stopped in a normal manner, and therefore it is not necessary to change various preset values after exchanging the battery. When the various portions of the apparatus are not stopped in the normal manner, the preset values might be set to the initial default values. Therefore, after exchanging the battery, these values have to be changed into desired preset values.

In a preferable embodiment of the digital audio recording and reproducing apparatus according to the fifth aspect of the invention, when the output voltage of the power source becomes not higher than said second level during the recording operation using an external solid state memory which is detachably connected to the apparatus, data management information for currently recorded digital audio data is read out of RAM provided in the apparatus and is stored in a FAT area in the external solid state memory, and then the recording operation is stopped. In this case, to digital audio data stored in the external solid state memory is not wasted, but can be reproduced in a usual manner.

In another preferable embodiment of the digital audio recording and reproducing apparatus according to the fifth aspect of the invention, when the output voltage of the power source is in a range between a maximum value and a middle value between the maximum value and said first level, an indication representing this condition, and when the output voltage of the power source is in a range between said middle value and said first level, an indication representing this condition. In this case, when the output voltage of the power source is high, "FULL" may be displayed, when the output voltage is in a middle range, "HALF" may be displayed, when the output voltage reaches to the first level, "EMPTY" is displayed, and when the output voltage arrives at the second level. "BATTERY LOW" is displayed. Instead of these word indications, a graphical indication may be utilized.

Reference will now be made, by way of example, to the accompanying drawings, in which:
Fig. 1 is a block diagram showing a whole structure of an embodiment of the digital audio recording and reproducing apparatus according to the invention;
Fig. 2 is a plan view of the digital audio recording and reproducing apparatus shown in Fig. 1;
Fig. 3 is a block diagram illustrating a detailed structure of a major portion of the digital audio recording and reproducing apparatus shown in Fig. 1;
Figs. 4A-4D are schematic views depicting various connection modes between the digital audio recording and reproducing apparatus and the external computer,
Fig. 5 is a schematic view depicting an embodiment of the removable memory checking mechanism;
Fig. 6 is a flow chart representing successive steps in the plural file continuous reproduction mode;
Fig. 7 is a flow chart representing successive steps in the plural file repeat reproduction mode;
Fig. 8 is a schematic diagram showing the data storage structure of the external solid state memory; and
Fig. 9 is a graph illustrating a relationship between the decrease in the power source voltage and the displayed indications.

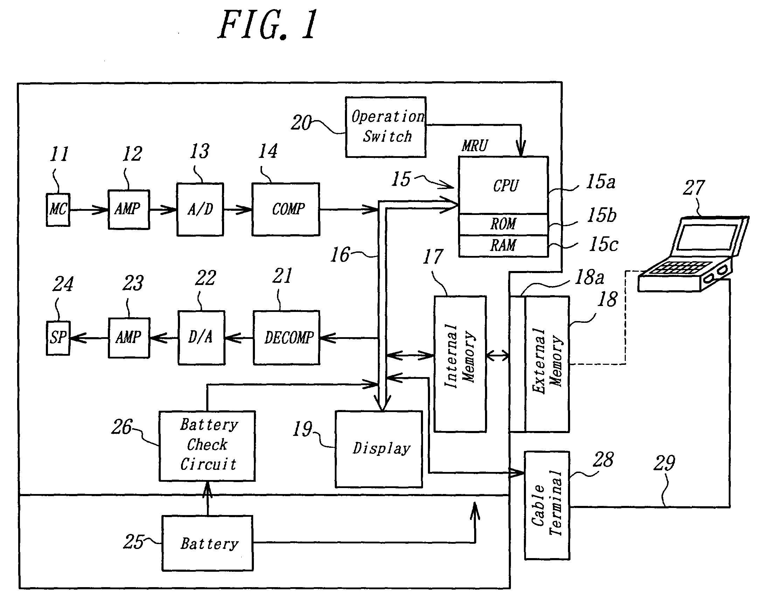

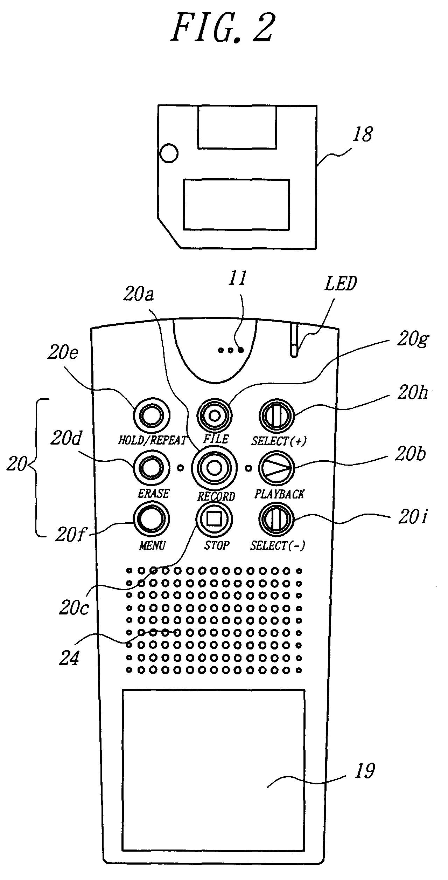

Fig. 1 is a block diagram showing a basic construction of an embodiment of the digital audio recording and reproducing apparatus according to the present invention, and Fig. 2 is a planview illustrating an outer appearance of this apparatus. An audio or speech signal collected by a microphone 11 is processed by an analog audio signal processing circuit 12 and is converted by an A/D converter 13 into a digital audio data. A sampling in the A/C converter 13 is carried out with eight bits and 8KHz. Then, according to the sampling theory, it is possible to recover the audio signal higher than 16 KHz with a fidelity and this is sufficient for reproducing a speech.

Then, the digital audio data is supplied from the A/D converter 13 to a compression circuit 14, and the compressed digital audio data is stored in an internal memory 17 or a removable memory 18 serving as a detachable external solid state memory via a data bus 16 under the control of a central processing unit (CPU) 15a installed in a main processing unit 15. When the removable memory 18 is connected to an external memory connecting terminal 18a, the digital audio data may be predominantly stored in the removable memory 18 or may be stored in either one of the internal memory 17 and external memory 18 selected by CPU 15a. The digital audio recording and reproducing apparatus further comprises a liquid crystal display 19 for displaying various kinds of commands and indicating information, and an operation switch unit 20. The main processing unit 15 comprises ROM 15b and RAM 15c in addition to the CPU 15a. The RAM 15c stores data information such as address of a sector in which the digital audio data is stored, a size of the digital audio data and dispersion information. The recording operation is completed by storing the data information in a FAT (File Allocation Table) area of the internal memory 17 or external memory 18.

When the recorded audio data is to be reproduced, the data information stored in the FAT area of the internal memory 17 or external memory 18 is first read out and is stored in the RAM 15c under the control of the central processing unit 15a. Then, a desired digital audio data is read out of the internal memory 17 or external memory 18 under to the control of the data information, and the thus read out digital audio data is supplied to a digital decompression circuit 21 and is decompressed thereby. The decompressed digital audio data is then supplied to D/A converter 22 and is converted into an analog audio signal. After processing the analog audio signal by an analog audio signal processing circuit 23, the audio signal is supplied to a speaker 24 and is converted thereby into an acoustic speech. Since the analog audio signal is also supplied to an earphone terminal, the audio signal may be reproduced by an earphone or headphone. There are further provided a power source 25 including a battery or batteries and a battery check circuit 26 for checking an output voltage of the battery 25.

As shown in Fig. 2, the digital audio recording and reproducing apparatus further comprises a light emitting diode LED which emits light during the recording and reproducing operations. For instance, during the recording, the LED may emit green light and during the reproduction, the LED may emit red light. The operation switch unit 20 includes recording button 20a, reproducing button 20b, stop button 20c, erase button 20d, hold/repeat button 20e, menu button 20f, file button 20g for reading out file numbers of digital data files, and up and down select buttons 20h and 20i for increasing and decreasing a data file number.

In the present embodiment, the digital compression circuit 14 is constructed such that the compressed digital audio data of sixty seconds, i.e. one minute has a data amount not larger than 100K bytes and can be treated on a conventional computer as a digital audio data file. When the computer works in the environment of Windows, the digital audio data file may be WAVE file which is a general sound file. In this case, if a conventional PCM compression of 22K bps (usual radio sound quality)is used to obtain compressed digital audio data, the compressed digital audio data of sixty seconds might amount to about 165K bytes. According to an embodiment of the invention, the digital audio data of sixty seconds is compressed to have not larger than 100K bytes. Therefore, the thus compressed data can be directly handled on the conventional computer, and a load for the computer upon execution can be substantially reduced.

The digital audio data compressed in the manner explained above is then stored in the internal solid state memory 17 or external solid state memory 18. In this case, various attribute data of the digital audio data such as title, date and file number may be also recorded, but here only the principal operation is explained.

In the present embodiment, the compression and decompression circuits 14 and 16 are constructed such that the recorded digital audio data has a data file format which can be directly treated on the conventional computer, and therefore the digital audio data can be simply transferred to an external computer 27. The digital audio recording and reproducing apparatus comprises an external memory connecting terminal 18a and the compressed digital audio data is stored in the removable memory 18 connected to the connecting terminal 18a. After recording, the removable memory 18 is removed from the apparatus and is set on the computer 27. Then, the digital audio data can be loaded to the computer in a usual manner. Alternately the digital audio data may be transferred to the computer 27 via a connection cable 28 connected between the digital audio recording and reproducing apparatus and the computer 27. In the present embodiment, since the digital audio data is recorded as the conventional sound file which can be directly treated by the computer 27, it is no more necessary to install a software for converting the digital audio data transmitted from the digital audio recording and reproducing apparatus into a computer readable audio data file format.

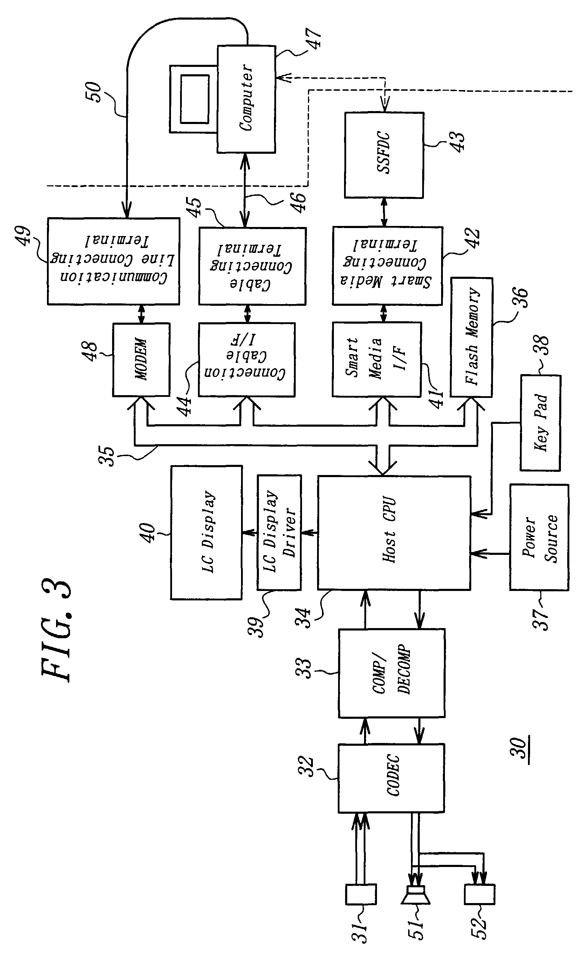

Fig. 3 is a block diagram illustrating a more detailed structure of a main portion of the digital audio recording and reproducing apparatus of the present embodiment. For the sake of explanation, portions similar to those shown in Fig. 1 are denoted by different numerical references from those used in Fig. 1. In the digital audio recording and reproducing apparatus 30, an analog audio signal converted by a microphone 31 is supplied to a CODEC 32 which performs both A/D conversion and D/A conversion in accordance with 8 bits and 8 KHz. Digital audio data converted by the CODEC 32 is then supplied to compression-decompression circuit (COMP/DECOMP) 33 and is compressed thereby. The COMP/DECOMP 33 may be formed by a CT8005 digital signal processor manufactured and sold by DSP GROUP INC. in U.S.A. This processor can derive a digital audio data file as "True Speech" (registered trade mark) which can be generally treated on DOS/V. This data format is based on the recommendation G723.1 of ITU-T, and this digital audio data file may be directly transmitted on a conventional telephone communication line.

The digital audio data of the DOS data file format generated by the processor 33 is converted into a WAVE file format, i.e. a sound file which can be reproduced by a computer operating in the Windows environment, under the control of the central processing unit (host CPU) 34, and the thus converted sound file is stored in an external solid state memory composed of a flash memory 36 via a data bus 35. To the host CPU 34 are connected a power source circuit 37, a key pad 38 and a liquid crystal display driver 40 to which a liquid crystal display 40 is connected.

To the data bus 35, is further connected a SSFDC interface 41, to which is detachably connected an external solid state memory consisting of SSFDC 43 by means of a SSFDC connecting terminal 42. The SSFDC 43 may have a storage capacity of 16-64 megabits. After recording the digital audio data on the SSFDC 43, the SSFDC is removed from the digital audio recording and reproducing apparatus 30 and is installed into an external computer 47. Then, the computer 47 can use the digital audio data in a usual manner. In the present embodiment, the digital audio data can be transmitted via the data bus 35 between the internal solid state memory, i.e. flash memory 36 and the external solid state memory consisting of SSFDC 43. Therefore, when both the 16 megabits flash memory 36 and the 16-64 megabits SSFDC 43 are jointly used, it is possible to record a speech having a very long time from 60-150 minutes.

To the data bus 35, is connected a communication cable interface 44, to which is connected a cable connecting terminal 45. By connecting a communication cable 46 to the cable connecting terminal 45, it is possible to transmit the digital audio data from the digital audio recording and reproducing apparatus 30 to the external computer 47.

To the data bus 35, are further connected a MODRM 48 and a communication line connecting terminal 49. By connecting a communication line 50 such a conventional telephone line and internet line to the terminal 49, the digital audio data may be transmitted to an external computer 47. It should be noted that the MODEM 48 may be constructed by a hardware or software. Since the digital audio file has the WAVE file format and its capacity is small, the digital audio signal can be transferred to the computer 48 within a short time period even by using the data communication line 50.

When a digital audio data file stored in the flash memory 36 or SSFDC 43 is to be reproduced, the relevant data file is read out under the control of the host CPU 34, and the thus read out digital audio data is supplied to the COMP/DECOMP 33 and is decompressed thereby. Then, the decompressed digital audio data is supplied to the CODEC 32 and is converted into an analog audio signal. After processing the analog audio signal by an analog processing circuit (18 in Fig. 1), the audio signal is converted into a sound by a speaker 51 or is supplied to an earphone jack 52.

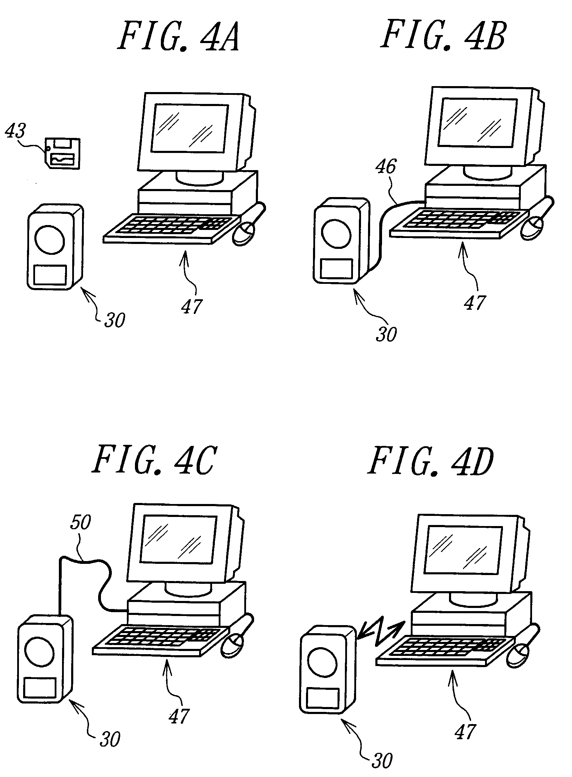

Fig. 4 depict various digital audio data transmission modes between the digital audio recording and reproducing apparatus 30 and the external computer 47. In Fig. 4A, the digital audio data is transferred with the aid of the external solid state memory, i.e. SSFDC 43, and in Fig. 4B, the digital audio data is transmitted from the apparatus 30 to the computer 47 via the communication cable 46. In Fig. 4C, the communication line 50 is used for transmitting the digital audio data from the apparatus 30 to the computer 47, and in Fig. 4D, the transmission of the digital audio data is performed by a radio or infra-red transmitter provided on the digital audio recording and reproducing apparatus 30.

In either transmission mode, since the transmitted digital audio data has a data file format which can be directly treated by the computer 47, it is no more necessary to provide any conversion software for converting the transmitted digital audio data into a computer readable audio data file. Moreover, the transmitted digital audio data file has a small capacity, the data transmission can be performed within a very short time period. This is particularly preferable for transmitting the digital audio data by means of the communication line, because the download time can be shortened and a communication cost can be saved.

In the present embodiment, the digital audio data file has the WAVE file format which is generally used in computers working in the environment of Windows, but any other file format may be utilized as long as it is based on the ITU-T recommendation G723.1 format. Moreover, in the present embodiment, the internal solid state memory is consisting of the flash memory 36 and the external solid state memory is formed by the SSFDC 43, but any kind of solid state memory such as semiconductor memory and magnetic stick may be used.

As explained above, according to an embodiment of the first aspect of the present invention, the digital audio data is compressed such that the data of sixty seconds is compressed to data having a capacity not larger than 100 KB and having a data file format, WAVE file which can be directly treated by the computer, the transmission of the data to the computer can be performed simply without using the special data converting cable as well as the conversion software. Moreover, the data transmission though the communication line or internet line can be completed within a short time period.

Furthermore, since the digital audio data can be transmitted between the internal memory 17 and the external memory 18, when the internal memory is full of the recorded audio data, the data may be transmitted to the external memory. Therefore, it is not necessary to waste the digital audio data stored in the internal memory. Further, when the external memory 18 is full of the stored data, the relevant external memory may be exchanged by another external solid state memory. In this manner, a user can continue the recording operation without worry about the available capacity of the memory.

Moreover, since the digital audio data can be transmitted from the computer 47 to the digital audio recording and reproducing apparatus 30 by means of the communication line 50, an audio message may be commonly transmitted from a computer installed at a head office to similar digital audio recording and reproducing apparatuses provided in a number of branches. Then, all the branches, the audio message can be reproduced by the respective digital audio recording and reproducing apparatuses. In this manner, the application of the digital audio recording and reproducing apparatus can be extended.

The digital audio recording and reproducing apparatus of the present invention further includes the feature of the second aspect of the present invention. That is to say, when the external removable memory 18 might be erroneously removed during the recording operation, the digital audio data so far stored in the internal memory 17 or external memory 18 can be held without being wasted and the thus held digital audio data can be reproduced in a usual manner.

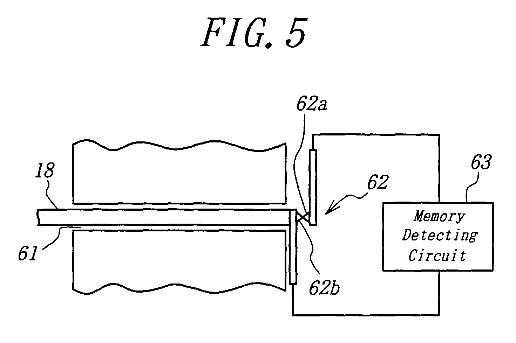

Fig. 5 is a schematic view showing an embodiment of a mechanism for detecting the insertion as well as removal of the removable memory 18 (see Fig. 1) with respect to the digital audio recording and reproducing apparatus. When the removable memory 18 is inserted into a slot 61 formed in a housing of the apparatus and a switch 62 is driven by a front end of the removable memory, switch contacts 62a and 62b are brought into contact with each other. When the removable memory 18 is removed, these switch contacts are separated from each other. Such on/off condition of the switch 62 is detected by a memory detecting circuit 63.

When the memory detecting circuit 63 detects the removal of the removable memory 18 during a recording operation, the data information including the attribute data of the relevant removable memory 18 stored in the RAM 15c of the main processing unit 15 during the relevant recording operation is not wasted, but is saved as it is. Then, the CPU 15a indicates on the LC display 19 a warning such that the removed memory should be inserted again. This warning may be "Insert the removed memory card".

In response to the warning, when a removable memory is inserted again and this is detected by the memory detecting circuit 63, attribute data of the inserted removable memory is first read out, and is then compared with attribute data of the previous removable memory stored in the RAM 15c. When it is judged that the newly inserted removable memory is identical with the previously used removable memory 18, the interrupted recording operation is restarted in accordance with the data information held in the RAM 15c. In this manner, the recording operation can be restarted without wasting the previously recorded audio information.

When it is judged that the newly inserted removable memory is different from that previously used removable memory 18, a warning is displayed on the LC display 19, said warning being "Wrong memory card. Insert the memory card removed in recording". In response to this warning, when the correct removable memory 18 is inserted again, the interrupted recording operation can be restarted in the manner just explained above. When the stop button 20c (Fig. 2) is pushed without inserting a removable memory, the data information held in the RAM 15c is wasted and the recording operation is completely stopped. Of course, in such a case, the audio information so far stored in the memory could not be reproduced.

In the present embodiment, the insertion and removal of the external memory 18 is detected by the switch 62 and memory detecting circuit 63, but a photoelectric detecting mechanism may be used. Furthermore, in the present embodiment, during the interruption of the recording operation, the speech signal could not be recorded, but the digital audio data obtained during a time period from the removal of the external removable memory to the restart of the recording operation may be stored in the internal memory 17. In this case, when it is detected that the removed memory 18 is inserted again, the digital audio data temporally stored in the internal memory 17 may be transmitted to the external memory 18. Then, the audio information can be still recorded even if the removable memory 18 is removed by an error.

In the present embodiment, as stated above, when the removable memory 18 is removed during the recording operation, the warning for recommending a user to insert the removed memory is displayed on the LC display 19, and when a different removable memory is inserted, the warning for recommending the user to insert the correct memory is displayed. The user can operate the apparatus without confusion and the erroneous operation of the user can be avoided.

Further, the digital audio recording and reproducing apparatus of the present embodiment has the third aspect of the invention. That is to say, an operation menu includes a normal reproduction mode in which a signal digital audio data file is reproduced only once (this is default menu), a single file repeat mode in which a single digital audio data file is reproduced repeatedly, a plural file continuous repeat mode in which a plurality of digital audio data files are successively reproduced only once, and a plural file repeat mode in which a plurality of digital audio data files are successively reproduced in a repeated manner, and a user can select any of these reproduction modes.

When the normal reproduction mode is selected, a denoted single digital audio data file is reproduced once as usual. When the plural file continuous reproduction mode is selected, a conventional reproducing operation is carried out, but a part of which is different. The plural file repeat reproduction mode is a novel one which has not been provided in known apparatuses. Therefore, the plural file continuous reproduction mode and plural file repeat reproduction mode will be further explained in detail. In the following explanation, for the sake of simplicity, a plurality of digital audio data files are stored in the internal solid state memory 17, but according to the invention, a plurality of digital audio data files may be stored in the external solid state memory 18 or may be stored in both the internal and external memories.

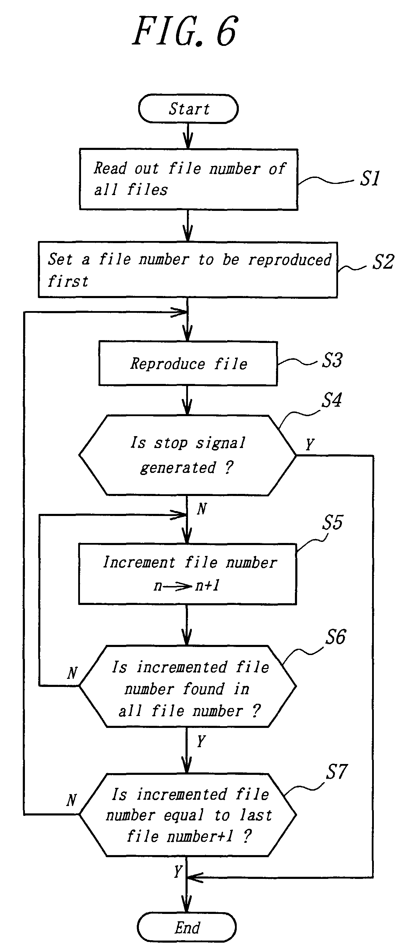

Fig. 6 is a flow chart showing successive steps in the plural file continuous reproduction mode. When this mode is selected, file numbers of all audio data files are read out of the data manage information stored in the FAT area of the internal solid state memory 17 (step S1), then a file number of a data file which is to be reproduced first is set by a user (step S2), and the relevant data file is reproduced (step S3). During the reproduction, it is always checked whether or not a stop signal is generated (step S4). When the stop signal is generated, the reproducing operation is stopped at once.

When the first data file has been completely reproduced, a file number is incremented by one (step S5), and it is checked whether or not the incremented file number is found in the initially read out file numbers of all data files (step S6). When the incremented file number is not found, the file number is incremented by one in the step S5. When the thus incremented file number is found in the initially read out file numbers, it is checked whether or not this file number corresponds to a sum of the last file number and one (step S7). If the incremented file number is not equal to said sum, then a data file of the incremented file number is reproduced.

In the step S7, when it is judged that the incremented file number is equal to the last file number plus one, the plural file continuous reproduction mode is completed. In this manner, the continuous reproduction can be carried out from the data file initially denoted by the user to the last data file. Therefore, data files which should not be apparently reproduced are not reproduced, and the file retrieve can be performed promptly and an accuracy of retrieve can be improved. Although not shown in the flow chart of Fig. 6, when the plural file continuous reproduction mode is selected, all the data files stored in the internal solid state memory 17 may be successively reproduced. In this case, in the step S2, a data file having the smallest file number may be reproduced first.

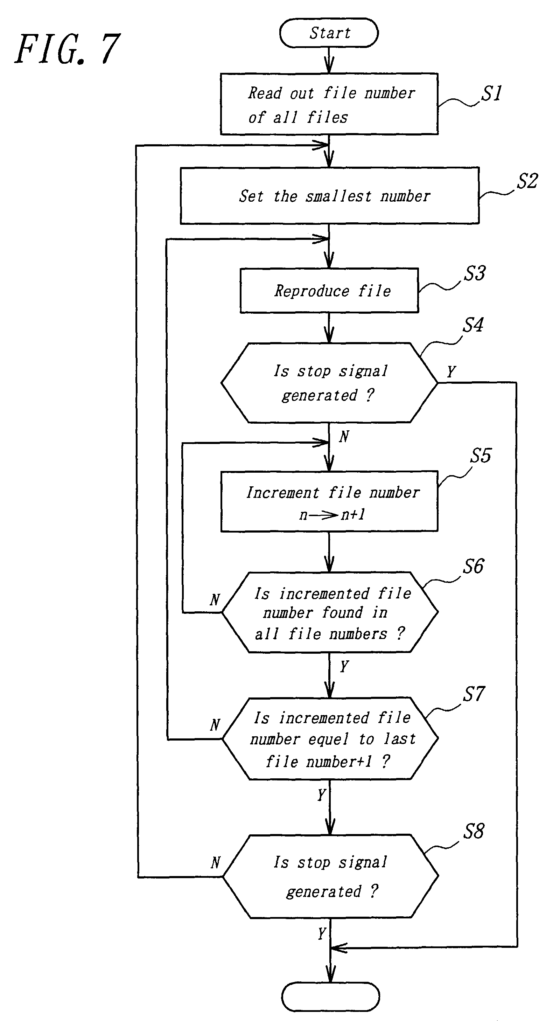

Fig. 7 is a flow chart illustrating successive steps in the plural file repeat reproduction mode. In the plural file repeat reproduction mode, all the digital audio data files stored in the internal solid state memory 17 are successively reproduced in a repeated manner, When this mode is selected, file numbers of all audio data files are read out of the data manage information stored in the FAT area of the internal solid state memory 17 (step S1). Next, the smallest file number is extracted as a file number which should be reproduced first (step S2), and the relevant data file is reproduced (step S3). During the reproduction, it is always checked whether or not a stop signal is generated (step S4). When the stop signal is generated, the reproducing operation is stopped at once.

When the first data file has been completely reproduced, a file number is incremented by one (step S5), and it is checked whether or not the incremented file number is found in the initially read out file numbers of all data files (step S6). When the incremented file number is not found, the file number is incremented again by one in the step S5. When the thus incremented file number is found in the initially read out file numbers, it is checked whether or not this file number corresponds to a sum of the last file number and one (step S7). If the incremented file number is not equal to said sum, then a data file of this incremented file number is reproduced.

In the step S7, when it is judged that the incremented file number is equal to the last file number plus one, it is checked whether or not a stop signal is generated (step S8). When the stop signal is generated, the plural file repeat reproduction mode is completed immediately. However, if not stop signal is generated, the operation is repeated from the step S2, and above explained steps S3-8 are repeated until the stop signal is generated. In this manner, all the digital audio data files stored in the internal solid state memory 17 can be successively reproduced repeatedly.

Furthermore, in the present embodiment, during the plural file continuous reproduction mode or plural file repeat reproduction mode, when a desired speech is seemed to be reproduced and the user pushes the repeat button 20e, the plural file continuous reproduction mode or plural file repeat reproduction mode is interrupted and the single file reproduction mode is automatically selected and the relevant digital audio data file is reproduced repeatedly. In this manner, it is possible to confirm easily and accurately whether or not a desired speech is reproduced. In this case, if the relevant speech is not a desired one or if the user wishes to find a next desired speech, the repeat button 20e is pushed again or the stop button 20c is pushed. Then, the interrupted plural file continuous reproduction mode or plural file repeat reproduction mode can be restarted.

In the present embodiment, in the plural file repeat reproduction mode, a plurality of digital audio data files stored in the internal solid state memory 17 are successively reproduced from a data file having the smallest file number. However, the order of reproduction may be denoted by the user. Furthermore, a special button for starting the plural file continuous reproduction mode or a special button for initiating the plural file repeat reproduction mode may be provided in the key pad 20.

The digital audio recording and reproducing apparatus of the present embodiment has the fourth aspect of the present invention. That is to say, the operation menu further includes a normal mode in which the normal speech information is recorded and reproduced, and an alarm mode in which the alarm message is recorded and reproduced. When the normal mode is selected, the compressed digital audio data is stored in a normal data storage area allocated in a data zone of the internal solid state memory 17, and only the digital files stored in this normal data storage area can be read out and erased. When the alarm mode is selected, a time at which the alarm message is reproduced can be set by the user, a digital audio data file of alarm message is stored in an alarm data storage area which is separately allocated from the normal data storage area, and only the alarm message file can be reproduced or erased.

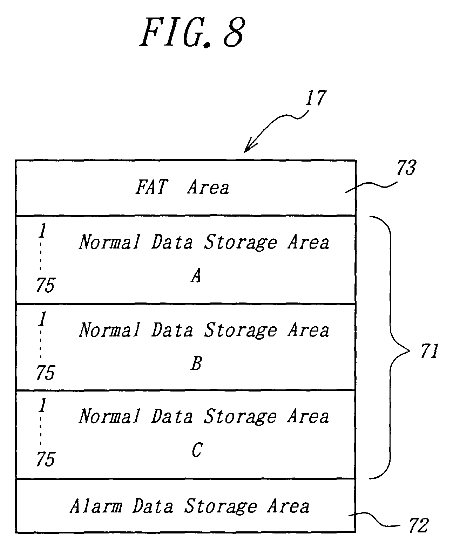

Fig. 8 is a plan view showing the structure of the internal solid state memory 17. A data zone is divided into a normal data storage zone 71 storing digital audio data files of normal speeches, an alarm data storage zone 72 for storing one or more digital audio data file of alarm message, and a FAT area 73 for storing data management information such as addresses of areas in which normal data and alarm data are stored, data sizes and distribution information. The normal data storage zone 71 is further divided into three sub-areas A-C, and each sub-area is divided into 1-75 file areas. An alarm message of thirty seconds is recorded with a compression rate of 8.5 K bps, and thus the alarm data storage area 72 has a size of 255 K bits.

When the menu button 20f is pushed, a selection image between the normal mode and the alarm mode, and a desired mode is selected by operating the select buttons 20h and 20i. When the normal mode is selected, the digital audio data is stored in the normal data storage zone 71, and a data file stored therein can be reproduced. Furthermore, a denoted data file stored in the normal data storage zone 71 can be selectively erased or all the data files stored in the normal data storage zone 71 can be erased simultaneously.

When the alarm mode is selected, at first a desired alarm time is set by the user. Next, digital audio data of an alarm message is stored in the alarm data storage area 72. In the present embodiment, upon setting the alarm time, it is not always necessary to record the alarm message. In such a case, an alarm sound is reproduced at the alarm time. Such a function is similar to the conventional schedule management function. Since the alarm massage stored in the alarm data storage area 72 can be erased only in the alarm mode, and therefore a possibility of erasing the alarm message by an error is very small.

In the present embodiment, the alarm mode is selected by operating the menu button 20f and select buttons 20h, 20i, but an alarm button may be provided. Only when the alarm button is pushed, the alarm message can be recorded and erased. Furthermore, a plurality of alarm messages may be stored in the alarm data storage area 72, and in such a case, respective alarm messages may be separately erased or simultaneously.

As explained above, in the fourth aspect of the invention, the data zone of the internal solid state memory 17 is divided into the normal data storage zone 71 and the alarm data storage area 72, and therefore the alarm message data stored in the alarm data storage area 72 could not be erased by the operation for erasing the normal data stored in the normal data storage zone 71. In this manner, a possibility of erasing the alarm data by an error can be reduced materially. Even in a digital audio recording and reproducing apparatus having a function for erasing all the data files simultaneously, the alarm data is not erased by this operation. Therefore, the user can use this function without worry about the erroneous erase of the alarm data.

The digital audio recording and reproducing apparatus of the present embodiment has the fifth aspect of the present invention. That is to say, even if the output voltage of the power source is decreased, the digital audio data so far stored in the memory is not lost and can be reproduced positively. As shown in Fig. 1, the output voltage is checked by the battery check circuit 26 and the detected output voltage is compared with four voltage levels. A digital signal representing a comparison result is supplied to the central; processing unit 15. In the present embodiment, the power source 25 includes a series connection of two batteries of 1.5 V, and ICs composing various circuits are operated at a nominal voltage of 3 V. ICs are sensitive to the applied voltage, and when the applied voltage is decreased, they do not work stably, and therefore the power source 25 includes a DC/DC converter for compensating the reduction in the output voltage even if the battery voltage is lowered.

Now it is assumed that an ending voltage of the battery is 0.9 V, and therefore when the output voltage of the power source 25 is reduced to 1.8 V(0.9×2), the power supply is shut down and the operation of the digital audio recording and reproducing apparatus is automatically stopped. In the present embodiment, when the output voltage of the power source 25 is higher than 2.44 V, "FULL" is displayed on the LC display 19. When the output voltage is reduced to 2.4 V, "HALF" is displayed, and when the output voltage is further reduced to 2.0 V, "EMPTY" is displayed. If one two batteries are exchanged by fully charged battery or batteries when "EMPTY" is displayed, no problem occurs. However, in practice, this "EMPTY" display could not recognized by the user or even recognized, no battery or batteries are available.

Under the above circumstances, the recording operation is continued and the output voltage of the power source 25 is decreased to or lower than 1.8 V, "BATTERY LOW" is displayed and the recording operation is automatically stopped without any operation of the user. That is to say, the data management information so far stored in the RAM 15c is transmitted to the removable memory 18 and is stored in its FAT area. Therefore, the digital audio data so far recorded on the removable memory 18 can be reproduced as usual. When the output voltage of the power source 25 is further decreased to 1.8 V or lower than 1.8 V, the power switch not shown is automatically switched into the off condition, and all the operation of the digital audio recording and reproducing apparatus is stopped.

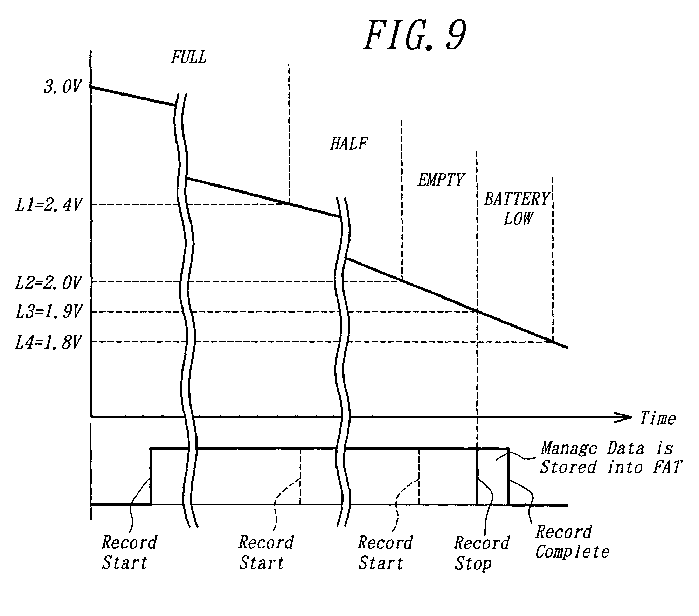

Fig. 9 is a graph showing the variation in the output voltage of the power source 25 and the display and recording operation. Initially the output voltage of the power source 25 is 3 V and is gradually deceased. Until the output voltage reaches the first comparison level L1=2.4 V, the "FULL" is displayed, and when the output voltage becomes not higher than 2.4 V, "HALF" is displayed instead of "FULL". When the output voltage becomes equal to or lower than the second comparison level L2=2.0 V, "EMPTY" is displayed instead of "HALF". When the output voltage is further deceased and arrives at the third comparison level L3=1.9 V, "BATTERY LOW" is displayed. After that, when the output power is decreased to the fourth comparison level L4=1.8 V without exchanging recharging the battery or batteries, the power switch is forcedly switched off and the power supply to the whole apparatus is stopped.

When the recording operation is started in the "FULL" or "HALF" or "EMPTY" condition, the normal recording operation is performed until the output voltage reaches the third comparison level L3=1.9 V. When the removable memory 18 is used, the compressed digital audio data is stored in the data storage area of the removable memory and the data management information for managing this digital audio data is stored in the RAM 15c. When the output voltage of the power source 25 reaches the third comparison level L3=1.9 V, the normal operation for stopping the recording operation is performed. That is to say, new digital audio data is not stored in the removable memory 18 and the data management information so far stored in the RAM 15c is transferred to the FAT area of the removable memory 18 and is stored therein. This operation is identical with the stopping operation effected by pushing the stop button 20c. Therefore, the digital audio data stored in the removable memory 18 can be reproduced in a usual manner.

It should be noted that the above mentioned comparison levels are denoted for the sake of explanation and may be set to any desired values in accordance with the output voltage of the power source and design. In the above embodiment, there are provided four indications in accordance with a magnitude of the output voltage, but according to the invention it is not always necessary to display "FULL" and "HALF". Moreover, when the recording operation is started while "EMPTY" is displayed, a time during which the recording will be possible may be displayed or a warning alarm may be produced.

As explained above, in apparatus embodying the fifth aspect of the present invention, the output voltage of the power source 25 is detected by the battery check circuit 26, and when the output voltage is higher than a threshold value at which the apparatus could not work correctly, but becomes not higher than a first level (corresponding to the second comparison level L2), this condition is displayed, when the output voltage is higher than the threshold value at which the apparatus could not work correctly, but becomes not higher than a second level (corresponding to the third comparison level L3), this condition is displayed, when the output voltage becomes not higher than said second level during the recording operation, data management information for currently recorded digital audio data is automatically stored and the recording operation is automatically stopped, and when the output voltage reaches a third level (corresponding to the fourth comparison level L4) which is lower than said second level but is slightly higher than the threshold value, the power supply to the various portions of the apparatus is stopped. Therefore, when the output voltage decreases to the second level, the recording operation can be automatically stopped in a usual manner without the manual stopping operation of the user, and thus the audio information so far recorded can be reproduced as usual. In this manner, the user can perform the recording operation without wary about the battery condition.

Unlike previously-proposed digital audio recording and reproducing apparatus with a back-up battery, no back-up battery is used in apparatus embodying the fifth aspect of the present invention, and therefore a possible failure in recording due to the discharge of the back-up battery can be prevented and a leakage of a battery liquid can be avoided.

It should be noted that the present invention is not limited to the above mentioned embodiment, but various alternations and modifications may be conceived by a person skilled in the art. For instance, in the above embodiment all five aspects of the present invention are included, but digital audio recording and reproducing apparatus embodying the invention may comprise any one, or any combination, of these five aspects. Furthermore, in the above embodiment, various warnings are displayed on the LC display, but sound warnings may be generated by the speaker.

## Claims

1. A digital audio recording and reproducing apparatus comprising:
an A/D converter for converting an analog audio signal collected by a microphone into digital audio data;
a digital compression circuit for compressing said digital audio data such that the analog audio signal of sixty seconds is converted into compressed digital audio data of not larger than 100K bytes;
an internal solid state memory for storing said compressed digital audio data;
a digital decompression circuit for decompressing said compressed digital audio data read out of said internal solid state memory to generate decompressed digital audio data;
a D/A converter for converting said decompressed digital audio data into an analog audio signal;
a reproducing means for reproducing said analog audio signal supplied from said D/A converter; and
an output means for outputting said compressed digital audio data to an external computer such that the compressed digital audio data has a file format which can be directly treated by the external computer.

2. A digital audio recording and reproducing apparatus according to claim 1, wherein said output means for outputting the compressed digital audio data to the external computer comprises a connecting terminal for connecting detachably an external solid state memory.

3. A digital audio recording and reproducing apparatus according to claim 2, wherein said external solid state memory is used to store the compressed digital audio data like as said internal solid state memory.

4. A digital audio recording and reproducing apparatus according to claim 2 or 3, wherein a digital data transmission is effected between said internal solid state memory and said external solid state memory.

5. A digital audio recording and reproducing apparatus according to claim 2, 3 or 4, wherein a digital audio signal stored in said external solid state memory is read out and is supplied to said decompression circuit.

6. A digital audio recording and reproducing apparatus according to claim 1, wherein said output means for outputting the compressed digital audio data to the external computer comprises a cable connecting terminal to which one end of a connection cable is detachably connected, the other end of said connection cable being connected to the external computer.

7. A digital audio recording and reproducing apparatus according to claim 1, wherein said output means for outputting the compressed digital audio data to the external computer comprises a transmitter which transmits the compressed digital audio data by means of a radio wave signal or an optical signal to a receiver provided in the external computer.

8. A digital audio recording and reproducing apparatus according to claim 1, wherein said output means for outputting the compressed digital audio data to the external computer comprises a modem and a communication line connecting terminal connected to said modem.

9. A digital audio recording and reproducing apparatus according to any preceding claim, wherein said internal solid state memory and external solid state memory are formed by a non-volatile semiconductor memory without a back-up battery.

10. A digital audio recording and reproducing apparatus according to any preceding claim, wherein said digital compression circuit is constructed such that the digital audio data is compressed in accordance with an audio coding system based on the ITU-T recommendation G723.1.

11. A digital audio recording and reproducing apparatus according to any preceding claim, wherein said file format of the compressed digital audio data outputted to the external computer is WAVE file, while the computer works in Windows.

12. A digital audio recording and reproducing apparatus comprising:
an A/D converter for converting an analog audio signal collected by a microphone into digital audio data;
a digital compression circuit for compressing said digital audio data into compressed digital audio data;
an internal solid state memory for storing said compressed digital audio data;
a digital decompression circuit for decompressing said compressed digital audio data read out of said internal solid state memory to generate decompressed digital audio data;
a D/A converter for converting said decompressed digital audio data into an analog audio signal;
a reproducing means for reproducing said analog audio signal supplied from said D/A converter; and
an external memory connecting terminal for connecting detachably an external solid state memory for storing said compressed digital audio data instead of or together with said internal solid state memory;
wherein when it is detected that the external solid state memory is removed from said external memory connecting terminal during a recording operation using the external solid state memory, the recording operation is temporally interrupted, and after detecting that the relevant external solid state memory is connected to said external memory connecting terminal, the interrupted recording operation is restarted.

13. A digital audio recording and reproducing apparatus according to claim 12, wherein when the external solid state memory is detected to be removed from the external memory connecting terminal during the recording operation using the external solid state memory, a waning for requesting a user to connect the relevant external slid state memory to the external memory connecting terminal is generated.

14. A digital audio recording and reproducing apparatus according to claim 12, wherein when it is detected that an external solid state memory different from the external slid state memory which has been removed from the external memory connecting terminal during the recording operation is connected to the external memory connecting terminal, a warning for indication that the currently connected external solid state memory is different from that removed during the recording operation is generated.

15. A digital audio recording and reproducing apparatus comprising:
an A/D converter for converting an analog audio signal collected by a microphone into digital audio data;
a digital compression circuit for compressing said digital audio data into compressed digital audio data;
an internal solid state memory for storing said compressed digital audio data;
a digital decompression circuit for decompressing said compressed digital audio data read out of said internal solid state memory to generate decompressed digital audio data;
a D/A converter for converting said decompressed digital audio data into an analog audio signal;
a reproducing means for reproducing said analog audio signal supplied from said D/A converter; and
an external memory connecting terminal for connecting detachably an external solid state memory for storing said compressed digital audio data instead of or together with said internal solid state memory;
wherein said apparatus includes;
a normal reproduction mode in which a signal digital audio data file selected from digital audio date files stored in said internal solid state memory and/or external solid state memory is reproduced only once;
a single file repeat mode in which a single digital audio data file selected from digital audio date files stored in said internal solid state memory and/or external solid state memory is reproduced repeatedly;
a plural file continuous repeat mode in which a plurality of digital audio data files stored in said internal solid state memory and/or external solid state memory are successively reproduced only once; and
a plural file repeat mode in which a plurality of digital audio data files stored in said internal solid state memory and/or external solid state memory are successively reproduced in a repeated manner.

16. A digital audio recording and reproducing apparatus according to claim 15, wherein in said plural file repeat reproduction mode, all digital audio data files stored in said internal solid state memory and/or external solid state memory are successively reproduced in a repeated manner.

17. A digital audio recording and reproducing apparatus according to claim 15, wherein in said plural file repeat reproduction mode, a plurality of digital audio data files selected from all digital audio data files stored in said internal solid state memory and/or external solid state memory are successively reproduced in a repeated manner.

18. A digital audio recording and reproducing apparatus according to claim 15, wherein in said plural file repeat reproduction mode, the order of reproducing a plurality of digital audio data files is set by a user.

19. A digital audio recording and reproducing apparatus according to claim 15, wherein a plurality of digital audio data files are stored in said internal solid state memory and/or external solid state memory with ordinal file numbers, and in said plural file continuous reproduction mode, a plurality of digital audio data files from a digital audio data file having a file number denoted by a user to a digital audio data file having the last file number are successively reproduced.

20. A digital audio recording and reproducing apparatus according to claim 15, wherein during said plural file continuous reproduction mode or plural file repeat reproduction mode, when a repeat button is operated by a user in response to a reproduction of a desired speech, said plural file continuous reproduction mode or plural file repeat reproduction mode is automatically interrupted and said single file repeat reproduction mode is automatically started to reproduce repeatedly a currently reproduced digital audio data file.

21. A digital audio recording and reproducing apparatus according to claim 15, wherein when said automatically started single file repeat reproduction mode is stopped in response to a user's operation, the interrupted plural file continuous reproduction mode or plural file repeat reproduction mode is restarted.

22. A digital audio recording and reproducing apparatus comprising:
an A/D converter for converting an analog audio signal collected by a microphone into digital audio data;
a digital compression circuit for compressing said digital audio data into compressed digital audio data;
an internal solid state memory for storing said compressed digital audio data;
a digital decompression circuit for decompressing said compressed digital audio data read out of said internal solid state memory to generate decompressed digital audio data;
a D/A converter for converting said decompressed digital audio data into an analog audio signal; and
a reproducing means for reproducing said analog audio signal supplied from said D/A converter;
wherein said internal solid state memory has a data zone divided into a normal data storage area storing digital audio data files of normal speeches and an alarm data storage area storing at least one digital audio data file of an alarm message, and the digital audio data file stored in the alarm data storage area could not be erased at least by a normal operation for erasing one or more digital audio data files stored in the normal data storage area.

23. A digital audio recording and reproducing apparatus according to claim 22, wherein in a normal reproduction mode, only the normal data storage area can be accessed, and in an alarm reproduction mode, only the alarm data storage area can be accessed.

24. A digital audio recording and reproducing apparatus according to claim 22 or 23, wherein when no alarm message is recorded, an alarm sound is generated at a time present by a user.

25. A digital audio recording and reproducing apparatus comprising:
an A/D converter for converting an analog audio signal collected by a microphone into digital audio data;
a digital compression circuit for compressing said digital audio data into compressed digital audio data;
an internal solid state memory for storing said compressed digital audio data;
a digital decompression circuit for decompressing said compressed digital audio data read out of said internal solid state memory to generate decompressed digital audio data;
a D/A converter for converting said decompressed digital audio data into an analog audio signal;
a reproducing means for reproducing said analog audio signal supplied from said D/A converter;
a power source for energizing said circuits and including at least one battery; and
a battery check circuit for checking an output voltage of said power supply;
wherein when the output voltage of the power source is higher than a threshold value at which the apparatus could not work correctly, but becomes not higher than a first level, this condition is displayed;
when the output voltage of the power source is higher than said threshold value, but becomes not higher than a second level, this condition is displayed;
when the output voltage of the power source becomes not higher than said second level during the recording operation, data management information for currently recorded digital audio data is automatically saved and the recording operation is automatically stopped.

26. A digital audio recording and reproducing apparatus according to claim 25, wherein when the output voltage of the power source reaches a third level lower than said second level but is slightly higher than said threshold value, the power supply to the various portions of the apparatus is automatically stopped.

27. A digital audio recording and reproducing apparatus according to claim 25, wherein when the output voltage of the power source becomes not higher than said second level during the recording operation using an external solid state memory which is detachably connected to the apparatus, data management information for currently recorded digital audio data is read out of RAM provided in the apparatus and is stored in a FAT area in the external solid state memory, and then the recording operation is stopped.

28. A digital audio recording and reproducing apparatus according to claim 25, wherein when the output voltage of the power source is in a range between a maximum value and a middle value between the maximum value and said first level, an indication representing this condition is displayed, and when the output voltage of the power source is in a range between said middle value and said first level, an indication representing this condition is displayed.

29. A digital audio recording and reproducing apparatus comprising:
an A/D converter for converting an analog audio signal collected by a microphone into digital audio data;
a digital compression circuit for compressing said digital audio data such that the analog audio signal of sixty seconds is converted into compressed digital audio data of not larger than 100K bytes;
an internal solid state memory for storing said compressed digital audio data;
a digital decompression circuit for decompressing said compressed digital audio data read out of said internal solid state memory to generate decompressed digital audio data;
a D/A converter for converting said decompressed digital audio data into an analog audio signal;
a reproducing means for reproducing said analog audio signal supplied from said D/A converter;
an output means for outputting said compressed digital audio data to an external computer such that the compressed digital audio data has a file format which can be directly treated by an external;
a power source for energizing said circuits and including at least one battery; and
a battery check circuit for checking an output voltage of said power supply;
wherein
when it is detected that the external solid state memory is removed from said external memory connecting terminal during a recording operation using the external solid state memory, the recording operation is temporally interrupted, and after detecting that the relevant external solid state memory is connected to said external memory connecting terminal, the interrupted recording operation is restarted:
said apparatus includes
a normal reproduction mode in which a signal digital audio data file selected from digital audio date files stored in said internal solid state memory and/or external solid state memory is reproduced only once;
a single file repeat mode in which a single digital audio data file selected from digital audio date files stored in said internal solid state memory and/or external solid state memory is reproduced repeatedly;
a plural file continuous repeat mode in which a plurality of digital audio data files stored in said internal solid state memory and/or external solid state memory are successively reproduced only once; and
a plural file repeat mode in which a plurality of digital audio data files stored in said internal solid state memory and/or external solid state memory are successively reproduced in a repeated manner:
said internal solid state memory has a data zone divided into a normal data storage area storing digital audio data files of normal speeches and an alarm data storage area storing at least one digital audio data file of an alarm message, and the digital audio data file stored in the alarm data storage area could not be erased at least by a normal operation for erasing one or more digital audio data files stored in the normal data storage area: and
when the output voltage of the power source is higher than a threshold value at which the apparatus could not work correctly, but becomes not higher than a first level, this condition is displayed;
when the output voltage of the power source is higher than said threshold value, but becomes not higher than a second level, this condition is displayed; and
when the output voltage of the power source becomes not higher than said second level during the recording operation, data management information for currently recorded digital audio data is automatically saved and the recording operation is automatically stopped.
